# EUROPÄISCHE PATENTSCHRIFT

(11) **EP 3 335 251 B1**
(45) Veröffentlichungstag und Bekanntmachung des Hinweises auf die Patenterteilung: **11.11.2020**
(21) Anmeldenummer: 16730358.5
(22) Anmeldetag: 16.06.2016
(51) Int. Cl.: H01L 41/047, H01L 41/293

(54) **HERSTELLUNGSVERFAHREN ZUM HERSTELLEN EINES ELEKTROMECHANISCHEN AKTORS UND ELEKTROMECHANISCHER AKTOR**
PRODUCTION METHOD FOR PRODUCING AN ELECTROMECHANICAL ACTUATOR, AND AN ELECTROMECHANICAL ACTUATOR
PROCÉDÉ DE FABRICATION D'UN ACTIONNEUR ÉLECTROMÉCANIQUE ET ACTIONNEUR ÉLECTROMÉCANIQUE

(30) Priorität: 14.08.2015 DE 102015215530
(43) Veröffentlichungstag der Anmeldung: 20.06.2018
(73) Patentinhaber: Vitesco Technologies GmbH, 30165 Hannover (DE)
(72) Erfinder: KREISSIG, Udo, 09114 Chemnitz (DE); LENK, Andreas, 01728 Bannewitz / OT Possendorf (DE); FRANZ-IMHOF, Christian, 04229 Leipzig (DE)
(74) Vertreter: Waldmann, Georg Alexander
(86) Internationale Anmeldenummer: PCT/EP2016/063885
(87) Internationale Veröffentlichungsnummer: WO 2017/028986

(56) Entgegenhaltungen:
- WO-A1-2005/075113
- DE-A1-102007 008 266
- DE-A1-102008 048 051
- DE-A1-102009 014 993
- JP-A- S6 384 174
- JP-A- S62 188 289

## Beschreibung

Die Erfindung betrifft ein Herstellungsverfahren zum Herstellen eines elektromechanischen Aktors sowie einen elektromechanischen Aktor, der insbesondere mit einem solchen Herstellungsverfahren hergestellt worden ist.

Elektromechanische Aktoren werden häufig, beispielsweise in Form von Piezostapeln, als Betätigungselemente verwendet, zum Beispiel in Einspritzventilen der verschiedensten Motortypen für Kraftfahrzeuge.

Solche elektromechanischen Aktoren weisen zumeist eine Mehrzahl von auf Anlegen eines elektrischen Feldes reagierenden Piezokeramikschichten und eine Mehrzahl von Elektrodenschichten auf, die alternierend entlang einer Längsachse aufeinander gestapelt angeordnet sind. Zumeist wird ein solcher Stapel an zwei sich gegenüberliegenden Seitenflächen elektrisch kontaktiert, um die Elektrodenschichten in dem Stapel ansteuern zu können, sodass sich ein elektrisches Feld innerhalb des Stapels ausbildet, auf das die Piezokeramikschichten dann durch Ausdehnung reagieren.

Um das elektrische Feld ausbilden zu können, werden zwei benachbarte Elektrodenschichten mit unterschiedlichen Potentialen angesteuert, das heißt die Kontaktierung nach außen endet an unterschiedlichen Kontaktierungsanschlüssen. Um diese unterschiedlichen Kontaktierungen realisieren zu können, ist es beispielsweise bekannt, nur jede zweite Elektrodenschicht bis an die Oberfläche der jeweiligen Seitenfläche heranzuführen, während sich die jeweils andere Elektrodenschicht nicht bis zu der Oberfläche dieser jeweiligen Seitenfläche hin erstreckt. Es ist jedoch auch bekannt, alle Elektrodenschichten allseitig bis an die Oberfläche der Seitenflächen des Stapels heranzuführen, sodass die Elektrodenschichten hervortreten, was große Vorteile hinsichtlich der Betätigung, Raumbeanspruchung und dem gesamten Betriebsverhalten des elektromechanischen Aktors hat. Bei einer solchen Anordnung ist jedoch die elektrische Kontaktierung der jeweiligen Elektrodenschichten schwieriger, da Überschläge zwischen zwei direkt benachbarten Elektrodenschichten an der Oberfläche des Stapels vermieden werden müssen.

In DE 10 2006 003 070 B3 ist beispielsweise beschrieben, dass zur Kontaktierung der Elektrodenschichten eine Isolationsschicht auf die komplette Oberfläche des Stapels aufgebracht wird, und dann diese Isolationsschicht an vorbestimmten Positionen entfernt wird.

In JP S63-84174, JP S62-188289 und DE 10 2008 048 051 A1 sind piezoelektrische Bauelemente gezeigt, bei denen auf Randbereichen des Schichtstapels der Bauelemente über jeder zweiten Innenelektrodenschicht eine Isolationsschicht angeordnet ist.

Es hat sich jedoch herausgestellt, dass eine komplette Beschichtung des Stapels mit einer Isolationsschicht nicht optimal ist, da beispielsweise Stirnflächen des Stapels wegen einer gewünschten Kraftübertragung frei verbleiben sollten und auch eine atmosphärische Abdichtung des Stapels nicht gewünscht ist. Zusätzlich hat sich herausgestellt, dass bei einer kompletten Beschichtung des Stapels häufig die Kantenüberdeckung nicht ausreichend ist.

Aufgabe der Erfindung ist es daher, ein Herstellungsverfahren zur Herstellung eines elektromechanischen Aktors vorzuschlagen, bei dem auf eine komplette Beschichtung des Stapels mit einer Isolationsschicht verzichtet werden kann, und dennoch eine sichere Isolierung von vorbestimmten Elektrodenschichten möglich ist.

Diese Aufgabe wird mit einem Herstellungsverfahren mit der Merkmalskombination des Anspruches 1 gelöst.

Ein elektromechanischer Aktor, der insbesondere mit einem solchen Herstellungsverfahren hergestellt worden ist, ist Gegenstand des nebengeordneten Anspruches 9.

Vorteilhafte Ausgestaltungen der Erfindung sind Gegenstand der abhängigen Ansprüche.

Bei einem Herstellungsverfahren zum Herstellen eines elektromechanischen Aktors wird zunächst ein als Stapel ausgebildetes elektrisches Bauelement bereitgestellt, das aus einer Mehrzahl von auf Anlegen eines elektrischen Feldes reagierenden Piezokeramikschichten und aus einer Mehrzahl von Elektrodenschichten gebildet ist, die entlang einer Längsachse des Stapels abwechselnd übereinander gestapelt sind, wobei die Elektrodenschichten an wenigstens zwei sich gegenüberliegenden, parallel zu der Längsachse angeordneten Seitenflächen des Stapels an einer Oberfläche des Stapels hervortreten. Dann wird auf vordefinierte Teilbereiche der beiden Seitenflächen ein Isolationsmaterial aufgebracht, und zwar derart, dass eine Schichtdicke des Isolationsmaterials in Richtung senkrecht zu der Längsachse des Stapels ausgehend von einer Längsmittelachse des jeweiligen Teilbereichs, die sich parallel zu der Längsachse erstreckt, zu zu der Längsachse parallel verlaufenden Rändern des jeweiligen Teilbereichs stetig ausläuft.
Es wird daher vorgeschlagen, statt im Gegensatz zu bekannten Verfahren, bei denen ein Stapel vollständig mit einem Isolationsmaterial beschichtet wird, nur vordefinierte Teilbereiche mit dem Isolationsmaterial zu bedecken. Diese vordefinierten Teilbereiche entsprechen dabei den Bereichen der Oberfläche der betreffenden Seitenfläche, an denen die Elektrodenschichten an die Oberfläche hervortreten. Somit wird entlang der Längsachse des Stapels jede Elektrodenschicht sicher mit dem Isolationsmaterial bedeckt. Bei der Beschichtung der vordefinierten Teilbereiche wird das Isolationsmaterial so auf die Oberfläche aufgebracht, dass die Schichtdicke zu den Rändern, die sich in Richtung der Längsachse des Stapels erstrecken, stetig ausläuft, wodurch die Haftung der Beschichtung unter mechanisch oder thermisch induzierter Spannung gewährleistet wird.

Als Isolationsmaterial wird dabei vorteilhaft ein Polyimid-Lack verwendet, der eine gute Temperaturbeständigkeit aufweist.

Nach Aufbringen des Isolationsmaterials auf die Oberfläche weist die Schichtdicke in der Mitte des jeweiligen Teilbereiches eine Dicke im Bereich zwischen 5 µm und 50 µm auf.

Durch das stetige Auslaufen verringert sich die Schichtdicke des Isolationsmaterials ausgehend von der Mitte des jeweiligen Teilbereiches stetig bis Null.

Vorteilhaft wird das Isolationsmaterial derart auf die Teilbereiche aufgebracht, dass ein Gradient der Schichtdicke des Isolationsmaterials von der Mitte ausgehend zu den Rändern des jeweiligen Teilbereiches in einem Bereich zwischen 5% und 100% gebildet wird. Dadurch wird vorteilhaft eine besonders gute Stabilität des Isolationsmaterials erzielt.

Bevorzugt ist es, wenn die Schichtdicke des Isolationsmaterials parallel zu der Längsachse des Stapels ausgehend von einer Mitte des jeweiligen Teilbereiches zu zu der Längsachse senkrecht verlaufenden Rändern des Teilbereiches hin ebenfalls stetig ausläuft. Dadurch wird eine Stabilität des Isolationsschichtmaterials auch parallel zu der Längsachse des Stapels erzielt.

In bevorzugter Ausgestaltung wird auf jeder der beiden Seitenflächen eine Maske mit den vordefinierten Teilbereichen entsprechenden vordefinierten Öffnungen in einem vorbestimmten Abstand zu der Oberfläche des Stapels angeordnet, und dann wird das Isolationsmaterial von einer dem Stapel abgewandten Maskenseite aus durch eine oder mehrere dieser Öffnungen hindurch auf die vordefinierten Teilbereiche der Oberfläche des Stapels aufgebracht.

Ein vorteilhafter Abstand der Maske zu der Oberfläche des Stapels liegt dabei in einem Bereich zwischen 0,1 mm und 4 mm.

Die Maske wird dabei vorzugsweise schwebend über der Oberfläche des Stapels gehalten, wobei beispielsweise Abstandshalter und entsprechende Führungen eingesetzt werden, um den vorbestimmten Abstand einzuhalten.

Vorteilhaft wird eine Maske bereitgestellt, deren Öffnungen so angeordnet sind, dass beim Aufbringen des Isolationsmaterials auf die Oberfläche des Stapels auf jeder der beiden Seitenflächen jede an die Oberfläche des Stapels hervortretende Elektrodenschicht zumindest bereichsweise sicher mit dem Isolationsmaterial bedeckt wird.

Besonders bevorzugt ist es, wenn eine Maske in Form einer Einwegmaske, die insbesondere an einem Endlosband bereitgestellt wird, verwendet wird.

Es ist vorteilhaft, wenn die Maske als Einmalmaske verwendet wird, da das Isolationsmaterial so nicht von der Einwegmaske entfernt werden muss.

Die bereitgestellte Maske ist dabei insbesondere aus einem temperatur- und lösungsmittelbeständigen Polymer, insbesondere aus einem faserverstärkten Kunststoff wie beispielsweise Aramid 410, gebildet.

Durch Verwendung einer über der Oberfläche des Stapels schwebenden Maske kann vorteilhaft einfach eine Beschichtung von lediglich Teilbereichen der Oberfläche an vordefinierten Stellen realisiert werden. Gleichzeitig kann die Schichtdicke des aufgebrachten Isolationsmaterials durch Einstellen eines vordefinierten Abstandes zu der Oberfläche des Stapels beeinflusst werden. Durch Verwendung der Maske, die beabstandet ist, wird erreicht, dass die Kanten des Isolationsmaterials nicht ausfransen, wie dies der Fall wäre, wenn die Maske in direktem Kontakt mit der Oberfläche des Stapels wäre bzw. es wird verhindert, dass das Isolationsmaterial unkontrolliert unter die Maske kriecht.

Durch Verwendung einer Maske in vordefiniertem Abstand kann daher eine kontrollierte Beschichtung der Elektrodenschichten erzielt werden.

Vorzugsweise wird das Isolationsmaterial als Lösung bereitgestellt und auf die Oberfläche des Stapels aufsprüht, wobei eine Viskosität der Lösung insbesondere in einem Bereich zwischen 4 Pa•s und 8 Pa•s liegt. Geeignete Lösungsmittel sind hier N-Ethylpyrrolidon (NEP), Dimethylpropylenharnstoff (DMPU), Dimethylformamid (DMF) oder N-Methylpyrollidon (NMP).

Das Sprühen der Lösung des Isolationsmaterials wird beispielsweise durch einen verfahrbaren Sprühkopf realisiert, der beispielsweise ein vordefiniertes Bahnmuster abfährt, um so eine definierte Beschichtung der Oberfläche mit dem Isolationsmaterial zu realisieren.

Die Viskosität der Lösung wird vorteilhaft durch den Anteil des jeweiligen Lösungsmittels in der Lösung eingestellt. Dadurch kann die Benetzbarkeit an den Sprühvorgang angepasst werden, denn wenn die Viskosität zu hoch ist, ist es nicht mehr möglich, die Lösung durch Aufsprühen auf die Oberfläche aufzubringen. Bei zu geringer Viskosität jedoch wäre die Schichtdicke zu gering und das Isolationsmaterial könnte in nachfolgenden Herstellungsschritten des elektromechanischen Aktors beschädigt werden.

Vorzugsweise wird nach dem Aufbringen des Isolationsmaterials auf die Oberfläche des Stapels an beiden Seitenflächen eine Schichtdicke des Isolationsmaterials vermessen, insbesondere durch optische Messung und/oder durch Wiegen, wobei das Vermessen insbesondere vor einem Trocknungs- und/oder Aushärteschritt durchgeführt wird.

Durch das Vermessen kann daher erfasst werden, ob eine ausreichende Menge an Isolationsmaterial auf die Oberfläche des Stapels aufgebracht worden ist und daher eine Isolation jeder an die Oberfläche hervortretenden Elektrodenschicht sicher gewährleistet ist.

Bei einem Wiegen wird dabei einfach der beschichtete Stapel vor Aufbringen des Isolationsmaterials und nach Aufbringen des Isolationsmaterials gewogen.

Alternativ kann bei einer optischen Messung der Schichtdicke beispielswiese ein Autofokussystem verwendet werden, das eine elektromagnetische Strahlung so auf die Oberfläche des Stapels aufstrahlt, dass eine optische Weglänge dieser elektromagnetischen Strahlung vermessen werden kann.

Vorteilhaft wird dabei eine Wellenlänge der elektromagnetischen Strahlung in einem Bereich gewählt, in dem das Isolationsmaterial transparent ist. Durch den bekannten Brechungsindex des Isolationsmaterials kann dann unter Vermessung der optischen Weglänge in dem Isolationsmaterial die Schichtdicke bestimmt werden.

Um Ausschuss bei der Herstellung des elektromechanischen Aktors größtenteils zu vermeiden, wird die Schichtdicke vorzugsweise bereits vor weiteren Schritten vermessen, um so eine Inline Beschichtungsmessung- bzw. prüfung durchzuführen.

Vorzugsweise wird ein Trocknungsschritt zum Trocknen des Isolationsmaterials durchgeführt, wobei das Isolationsmaterial insbesondere bei einer Temperatur zwischen 40 °C und 80 °C und einer maximalen relativen Luftfeuchte von 30% getrocknet wird. Bevorzugt wird der Trocknungsschritt dabei in einem Ofen unter definierter relativer Luftfeuchtigkeit und definierter Temperatur ausgeführt. Bei einer zu geringen Temperatur besteht die Gefahr, dass sich eine ungleichmäßige Schicht ausbildet, während die relative Luftfeuchte einen Einfluss auf eine mögliche chemische Zersetzung der Isolationsschicht hat.

In bevorzugter Ausgestaltung wird ein Aushärteschritt zum Aushärten des Isolationsmaterials durchgeführt, wobei das Isolationsmaterial insbesondere bei einer Temperatur zwischen 200 °C und 360 °C an Luft ausgehärtet wird. Vorteilhaft wird der Aushärteschritt nach dem Trocknungsschritt durchgeführt. Insbesondere wird dabei ein Temperaturgradient von maximal 50 °C pro Minute verwendet, um die Bildung von Spannungsrissen zu vermeiden. Das Aushärten wird in einem Zeitraum zwischen 1 Stunde und 2,5 Stunden durchgeführt.

Vorteilhaft wird am Ende des Herstellungsverfahrens jede zweite entlang der Längsachse angeordnete Elektrodenschicht, die nun unter dem Isolationsmaterial des Teilbereiches angeordnet ist, durch Bildung eines definierten Grabens freigelegt, beispielsweise durch lokale Laserablation des Isolationsmaterials. Dabei werden die Gräben vorteilhaft so ausgebildet, dass sie zu den parallel zu der Längsachse sich erstreckenden Rändern des jeweiligen Teilbereiches jeweils beabstandet sind. So wird einerseits eine gute Kontaktierung der jeweiligen Elektrodenschicht und andererseits eine gute Isolation der kontaktierten Elektrodenschicht erreicht.

Ein elektromechanischer Aktor, der insbesondere mit einem oben beschriebenen Herstellungsverfahren hergestellt worden ist, weist ein als Stapel ausgebildetes elektrisches Bauelement auf, das aus einer Mehrzahl von Piezokeramikschichten und aus einer Mehrzahl von Elektrodenschichten gebildet ist, die entlang einer Längsachse entlang des Stapels abwechselnd übereinander gestapelt sind, wobei die Elektrodenschichten an wenigstens zwei sich gegenüberliegenden, parallel zu der Längsachse angeordneten Seitenflächen des Stapels an eine Oberfläche des Stapels hervortreten. Der Stapel weist auf vordefinierten Teilbereichen der beiden Seitenflächen ein Isolationsmaterial auf, und zwar derart, dass eine Schichtdicke des Isolationsmaterials in Richtung senkrecht zu der Längsachse des Stapels ausgehend von einer Längsmittelachse des jeweiligen Teilbereiches, die sich parallel zu der Längsachse erstreckt, zu zu der Längsachse parallel verlaufenden Rändern des jeweiligen Teilbereichs hin auslaufend ausgebildet ist.

Nach dem Trocknen und Aushärten des Isolationsmaterials auf der Oberfläche bildet sich ein Isolationsmaterial aus, das in dem Bereich der Oberfläche, in dem die Elektrodenschichten an die Oberfläche hervortreten, eine Schichtdicke von etwa 5 µm bis 50 µm aufweist. Dies ist ausreichend, um die Elektrodenschichten sicher zu isolieren. Um ein mechanisch stabiles Isolationsmaterial zu realisieren, weisen die Teilbereiche keine geradlinigen, das heißt senkrecht zur Längsachse ausgebildeten, Ränder auf, sondern sind an den Rändern auslaufend ausgebildet, sodass sich die Schichtdicke an den Rändern stetig bis auf eine Schichtdicke von 0 verringert. Dadurch wird die Haftung des Isolationsmaterials an der Oberfläche des Stapels auch unter mechanisch oder thermisch induzierter Spannung gewährleistet.

Vorteilhaft weist ein jeweiliger Teilbereich in einem Querschnitt senkrecht zu der Längsachse des Stapels eine trapezförmige Längsschnittf orm mit einem Plateaubereich auf. Das bedeutet, in dem Bereich um die Längsmittelachse herum ist der jeweilige Teilbereich plan ausgebildet, um eine konstante Schichtdicke bereitzustellen. Das stetige Auslaufen beginnt erst an den Rändern, wodurch die trapezförmige Querschnittform entsteht. Es bilden sich daher zwei symmetrisch zu der Längsmittelachse ausgebildete Auslaufbereiche an den jeweiligen Teilbereichen dort.

Insgesamt wird daher eine Beschichtung der Elektrodenschichten in dem Bereich, in dem sie an die Oberfläche des Stapels hervortreten, mittels Sprühen beispielsweise eines Polyimid-Lackes geeigneter Viskosität durch eine schwebende Einmalmaske hindurch realisiert. Dazu kommt ein spezieller Trocken- und Aushärteprozess, sodass die entstehenden Teilbereiche mechanischen bzw. thermischen Spannungen eine gute Widerstandskraft entgegensetzen können.

Vorteilhafte Ausgestaltungen der Erfindung werden nachfolgend anhand der beigefügten Zeichnungen näher erläutert. Dabei zeigt:
- Fig. 1: eine perspektivische Darstellung eines elektromechanischen Aktors, der ein als vollaktiver Stapel ausgebildetes elektrisches Bauelement aus Piezokeramikschichten und Elektrodenschichten aufweist;
- Fig. 2: eine Längsschnittdarstellung des elektrischen Bauelementes aus Fig. 1, bei dem an zwei sich gegenüberliegenden Seitenflächen Elektrodenschichten jeweils an eine Oberfläche des Stapels hervortreten;
- Fig. 3: eine schematische Darstellung von Schritten eines Herstellungsverfahrens zum Herstellen eines elektromechanischen Aktors entsprechend Fig. 1;
- Fig. 4: eine Querschnittdarstellung des in Fig. 2 dargestellten Bauelementes durch eine Elektrodenschicht, wobei das Auftragen von Isolationsmaterial auf einen Teilbereich der Oberfläche durch eine Maske hindurch dargestellt ist;
- Fig. 5: eine perspektivische Darstellung eines Endlosbandes, das die in Fig. 4 dargestellte Maske bereitstellt;
- Fig. 6: eine Draufsicht auf die Maske in Fig. 4 bzw. Fig. 5 von oben;
- Fig. 7: das elektrische Bauelement aus Fig. 4 nach einem Trocknungs- und Aushärteschritt;
- Fig. 8: eine perspektivische Ansicht des elektronischen Bauelements aus Fig. 7, nachdem in dem Isolationsmaterial Gräben zum Kontaktieren jeder zweiten Elektrodenschicht gebildet worden sind;
- Fig. 9: eine perspektivische Ansicht eines mit dem in Fig. 3 beschriebenen Verfahren erzeugten Piezoriegels in einer ersten Ausführungsform; und
- Fig. 10: eine perspektivische Ansicht eines mit dem in Fig. 3 beschriebenen Verfahren erzeugten Piezoriegels in einer zweiten Ausführungsform.

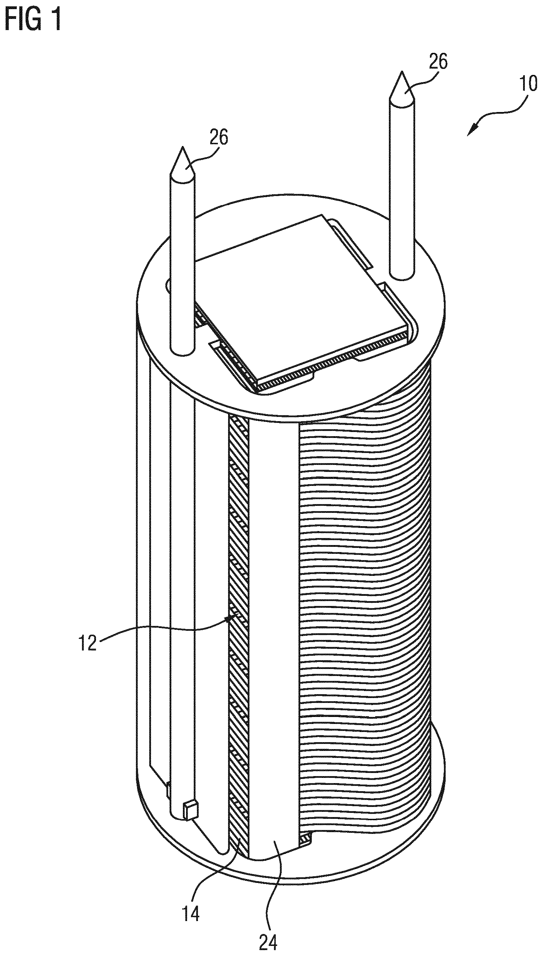

Fig. 1 zeigt einen elektromechanischen Aktor 10, der ein elektrisches Bauelement 12 aufweist, das als Stapel 14 ausgebildet ist, wobei eine Mehrzahl von auf Auflegen eines elektrischen Feldes reagierenden Piezokeramikschichten 16 und eine Mehrzahl von Elektrodenschichten 18 abwechselnd derart entlang einer Längsachse 20 aufeinander gestapelt sind, dass jede Elektrodenschicht 18 zwischen zwei Piezokeramikschichten 16 angeordnet ist. Auf einer Seitenfläche 22 des Stapels 14 ist wenigstens eine Außenkontaktierung in Form einer Außenelektrode 24 aufgebracht, die elektrisch mit einem Kontaktierungspin 26 verbunden ist. Über den Kontaktierungspin 26 kann ein elektrisches Potential an die jeweilige kontaktierte Elektrodenschicht 18 weitergeleitet werden. Jeweils zueinander benachbarte Elektrodenschichten 18 können mit unterschiedlichen elektrischen Potentialen beaufschlagt werden, um so ein elektrisches Feld in dem Stapel 14 zu erzeugen. Damit die Piezokeramikschichten 16 sich in ihrer Länge entlang der Längsachse 20 verändern können, sind zwei Kontaktierungspins 26 vorhanden, über die jeweils ein unterschiedliches Potential an den Stapel 14 herangeführt wird.

In der vorliegenden Ausführungsform in Fig. 1 ist der Stapel 14 als sogenannter "vollaktiver Piezostapel" ausgebildet, das heißt die Elektrodenschichten 18 erstrecken sich allseitig bis an eine Oberfläche 28 des Stapels 14. Ein vollaktiver Piezostapel, bei dem die Elektrodenschichten 18 allseitig an die Oberfläche 28 der Seitenflächen 22 herangeführt sind, hat den Vorteil, dass bei kleinerer Raumbeanspruchung wenigstens ein gleiches Ausdehnungsverhalten oder sogar noch ein größeres Ausdehnungsverhalten erzielt werden kann als bei Piezostapeln, die nicht vollaktiv sind, das heißt bei denen die Elektrodenschichten 18 abwechselnd von einer Oberfläche 28 des Stapels 14 ausgehend in den Stapel 14 hinein zurückversetzt angeordnet sind.

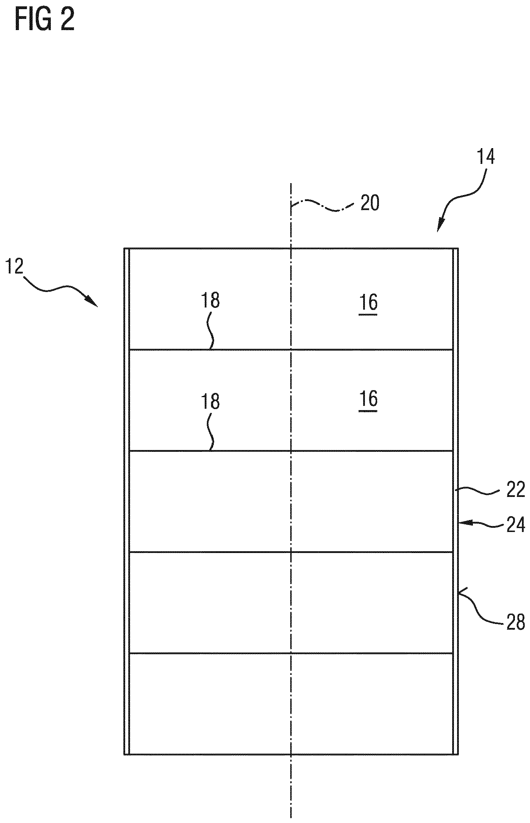

Fig. 2 zeigt eine Längsschnittdarstellung des elektrischen Bauelementes 12 aus Fig. 1, wobei die Außenelektroden 24 an zwei sich gegenüberliegenden Seitenflächen 22 des Stapels 14 angeordnet sind.

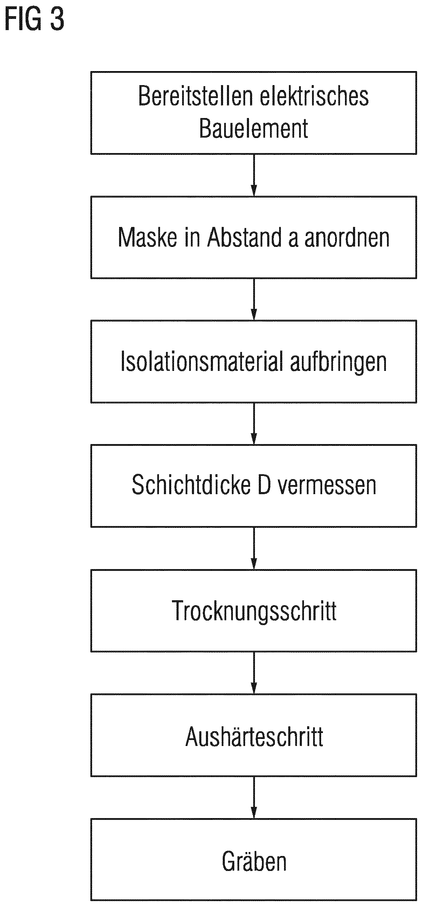

Um einen Überschlag zwischen den über die beiden Kontaktierungspins 26 und die beiden Außenelektroden 24 aufgebrachten unterschiedlichen Potentialen zu vermeiden, ist es nötig, auf die Oberfläche 28 des Stapels 14 an den Seitenflächen 22, an denen die Außenelektroden 24 befestigt werden, ein Isolationsmaterial 30 aufzubringen, um so entlang der Längsachse 20 jede zweite Elektrodenschicht 18 von der Außenelektrode 24 zu isolieren. Daher wird, wie nachfolgend mit Bezug auf Fig. 3 beschrieben wird, auf vordefinierten Teilbereichen 32 an der Oberfläche 28, nämlich dort, wo die Elektrodenschichten 18 an die Oberfläche 28 des Stapels 14 hervortreten, das Isolationsmaterial 30 aufgebracht.

Damit das Isolationsmaterial 30 stabil ist gegen mechanische und thermische Beanspruchungen, ist es von Vorteil, wenn die Teilbereiche 32 zumindest senkrecht zu der Längsachse 20 keine konstante Schichtdicke D aufweisen, sondern in Richtung senkrecht zu der Längsachse 20 ausgehend von einer Längsmittelachse 60 des jeweiligen Teilbereichs 32, die parallel zu der Längsachse 20 verläuft, zu Rändern 38 des jeweiligen Teilbereiches 32 hin, die sich parallel zu der Längsachse 20 erstrecken, stetig ausläuft.

Ein entsprechendes Verfahren, mit dem solche Teilbereiche 32 gebildet werden können, wird nun mit Bezug auf das in Fig. 3 gezeigte Flussdiagramm beschrieben, in dem die einzelnen Schritte des Herstellungsverfahrens dargestellt sind.

In einem ersten Schritt wird dabei zunächst das elektrische Bauelement 12 bereitgestellt, das die Mehrzahl an Piezokeramikschichten 16 und die Mehrzahl an Elektrodenschichten 18 aufweist, welche allseitig bis an die Seitenflächen 22 an die Oberfläche 28 des Stapels 14 hervortreten.

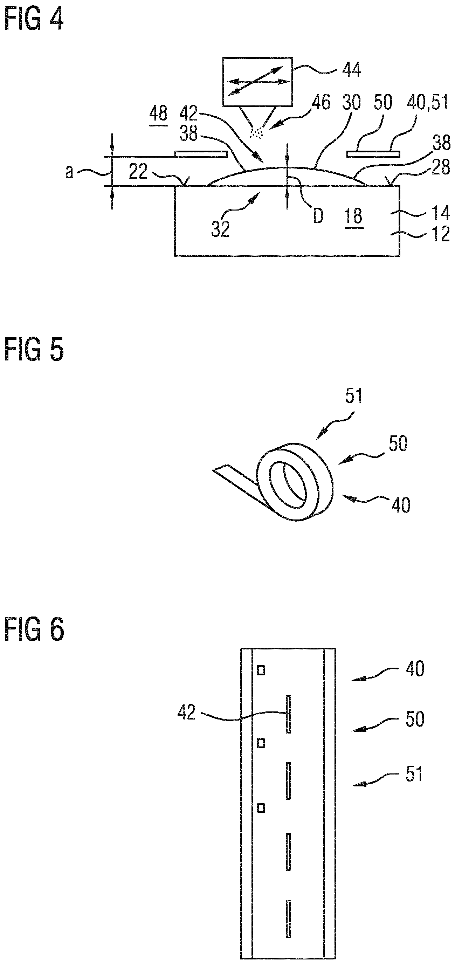

Danach wird in einem nächsten Schritt eine Maske 40 in einem definierten Abstand a über der Oberfläche 28 des Stapels 14 an einer jeweils mit dem Isolationsmaterial 30 zu beschichtenden Seitenfläche 22 angeordnet. Dazu werden beispielsweise Abstandshalter und Führungseinrichtungen verwendet, um den definierten Abstand a zu der Oberfläche 28 einhalten zu können. Die Maske 40 weist, wie in Fig. 6 in der Draufsicht auf die Maske 40 zu sehen ist, vordefinierte Öffnungen 42 auf, die so auf der Maske 40 angeordnet sind, dass das Isolationsmaterial 30, das dadurch strukturiert wird, später die vordefinierten Teilbereiche 32 bildet. Daher entsprechen die vordefinierten Öffnungen 42 in der Maske 40 den vordefinierten Teilbereichen 32. Wie die Maske 40 in einem Abstand a zu der Oberfläche 28 des Stapels 14 angeordnet wird, ist in einer Detailansicht des elektrischen Bauelementes 12 in Fig. 4 dargestellt.

Ein Sprühkopf 44, der eine Lösung 46 des Isolationsmaterials 30 in einem Lösungsmittel aufweist, fährt mit vordefinierten Bahnen über eine von dem Stapel 14 abgewandte Maskenseite 48 und sprüht die Lösung 46 durch die Öffnungen 42 hindurch auf die Oberfläche 28 des Stapels 14. Die Maske 40 schwebt dabei über der Oberfläche 28 in dem vordefinierten Abstand a, der sich in einem Bereich zwischen 0,1 mm und 4 mm bewegt. Dadurch werden Effekte wie das Ausfransen der Ränder 38 des Isolationsmaterials 30 bzw. das Unterlaufen der Maske 40 mit der Lösung 46 vermieden.

Die Maske 40 wird vorteilhaft an einem in Fig. 5 dargestellten Endlosband 50 bereitgestellt und bildet eine Einwegmaske 51, die lediglich für einen einzigen Beschichtungsschritt verwendet wird, und danach verworfen wird.

Nachdem demgemäß die Maske 40 mit einem Abstand a über der Oberfläche 28 angeordnet ist, wird das Isolationsmaterial 30 in einem nächsten Schritt in Form der Lösung 46 über den Sprühkopf 44 auf die Oberfläche 28 aufgebracht, wie dies in Fig. 4 dargestellt ist.

In einem nächsten Schritt des Herstellungsverfahrens, das in Fig. 3 dargestellt ist, wird dann die Schichtdicke D des aufgebrachten Isolationsmaterials 30 vermessen, beispielsweise, indem der Stapel 14 gewogen wird, oder indem ein optisches Messverfahren durchgeführt wird.

Nach dem Vermessen der Schichtdicke D wird ein Trocknungsschritt bei Temperaturen zwischen 40 °C und 80 °C in einem Ofen mit einer maximalen relativen Luftfeuchte von etwa 30% durchgeführt. Danach erfolgt ein Aushärteschritt, wobei das Isolationsmaterial 30 bei einer Temperatur zwischen 280 °C und 360 °C an Luft ausgehärtet wird. Dabei ist darauf zu achten, dass ein Temperaturgradient von maximal 50 °C pro Minute verwendet wird, um Spannungsrisse in dem Isolationsmaterial 30 zu vermeiden.

Am Ende des Herstellungsverfahrens werden, beispielsweise durch Laserablation, Gräben 52 in dem Isolationsmaterial 30 gebildet, die entlang der Längsachse 20 jede zweite, von dem Isolationsmaterial 30 bedeckte, Elektrodenschicht 18 freilegen. Die Gräben 52 erstrecken sich dabei nicht vollständig über eine senkrecht zu der Längsachse 20 angeordnete Breite des jeweiligen Teilbereiches 32, sondern sind beidseitig von den Rändern 38 des Teilbereiches 32 beabstandet angeordnet. So wird einerseits eine sichere Isolierung einer zu kontaktierenden Elektrodenschicht 18 bei einer gleichzeitig guten Kontaktierungsmöglichkeit bereitgestellt.

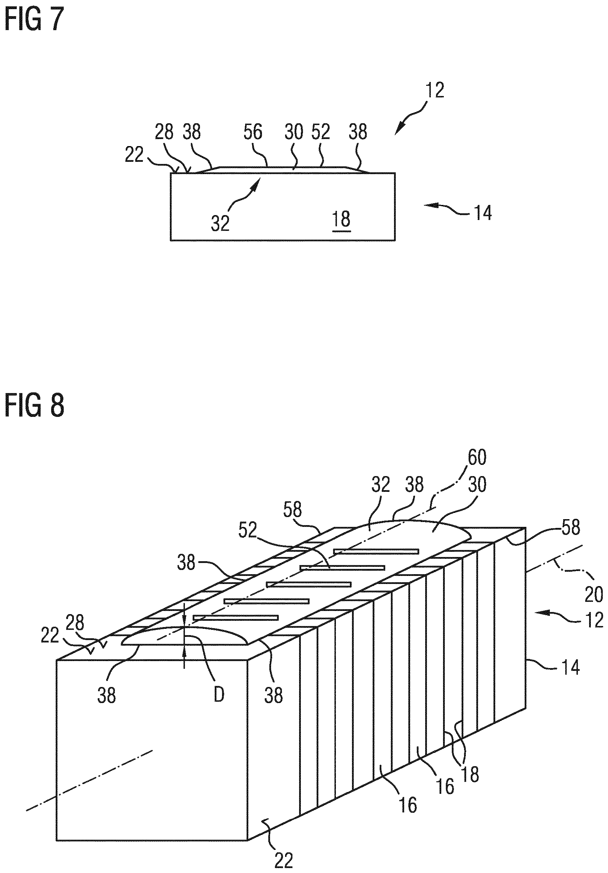

Fig. 7 zeigt eine Detailansicht des elektrischen Bauelementes 12 aus Fig. 2, nachdem das Isolationsmaterial 30 ausgehärtet ist.

Es ist zu sehen, dass der Teilbereich 32, der die Elektrodenschichten 18 elektrisch isoliert, in unmittelbarem Bereich um die Längsmittelachse 60 herum plan ausgebildet ist, und an den Rändern 38 stetig ausläuft. Durch die plane Ausbildung um die Längsmittelachse 60 des Teilbereiches 32 herum entsteht ein Plateaubereich 56, der eine sichere Isolierung der Elektrodenschichten 18 garantiert.

Fig. 8 zeigt eine perspektivische Ansicht des elektronischen Bauelements aus Fig. 7, nachdem die Gräben 52 in dem Teilbereich 32 gebildet worden sind. Es ist zu sehen, dass der Teilbereich 32 von Stapelkanten 58, die parallel zu der Längsachse 20 verlaufen, jeweils beabstandet angeordnet ist. Er ist dabei symmetrisch um die Längsmittelachse 60 des Teilbereichs 32 ausgebildet.

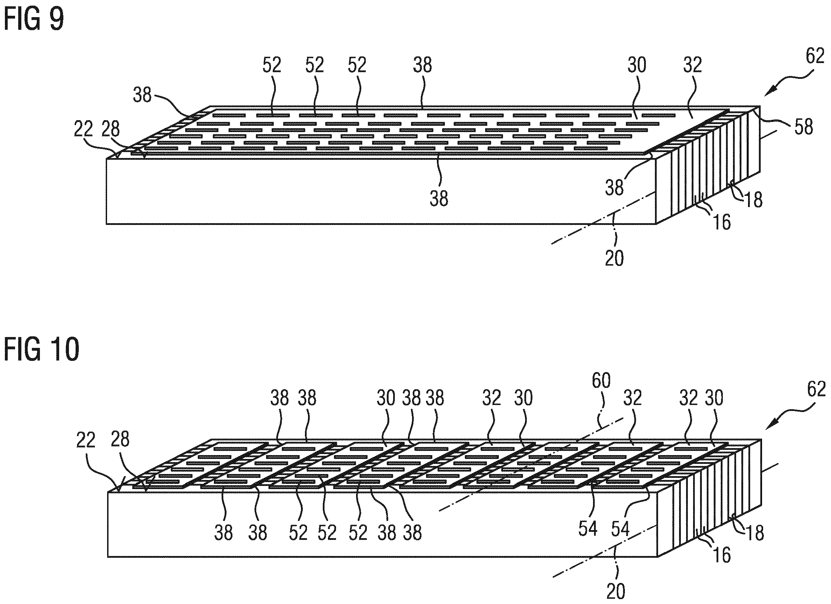

Fig. 9 und Fig. 10 zeigen Piezoriegel 62, die mit einem Herstellungsverfahren gemäß Fig. 3 erzeugt worden sind. Dabei ist in einer ersten Ausführungsform, gezeigt in Fig. 9, der Piezoriegel 62 bis auf Randbereiche durgängig beschichtet, während der Piezoriegel 62 in einer zweiten Ausführungsform gemäß Fig. 10 Aussparungen in dem Isolationsmaterial 30 aufweist, wo später eine Trennung des Piezoriegels 62 in einzelne Stapel 14 erfolgt.

## Patentansprüche

1. Herstellungsverfahren zum Herstellen eines elektromechanischen Aktors (10), aufweisend die Schritte:
- Bereitstellen eines als Stapel (14) ausgebildeten elektrischen Bauelements (12), das aus einer Mehrzahl von Piezokeramikschichten (16) und aus einer Mehrzahl von Elektrodenschichten (18) gebildet ist, die entlang einer Längsachse (20) des Stapels (14) abwechselnd übereinander gestapelt sind, wobei die Elektrodenschichten (18) an wenigstens zwei sich gegenüberliegenden, parallel zu der Längsachse (20) angeordneten Seitenflächen (22) des Stapels (14) an eine Oberfläche (28) des Stapels (14) hervortreten;
- Aufbringen von Isolationsmaterial (30) derart auf vordefinierte Teilbereiche (32) der beiden Seitenflächen (22), dass eine Schichtdicke (D) des Isolationsmaterials (30) in Richtung senkrecht zu der Längsachse (20) des Stapels (14) ausgehend von einer Längsmittelachse (60) des jeweiligen Teilbereiches (32), die sich parallel zu der Längsachse (20) erstreckt, zu zu der Längsachse (20) parallel verlaufenden Rändern (38) des jeweiligen Teilbereiches (32) hin stetig ausläuft,
- Ausbilden von Gräben (52) in dem Isolationsmaterial (30), die entlang der Längsachse (20) jede zweite, von dem Isolationsmaterial (30) bedeckte Elektrodenschicht (18) freilegen, wobei die Gräben (52) beidseitig von den Rändern (38) der Teilbereiche (32) beabstandet angeordnet sind.

2. Herstellungsverfahren nach Anspruch 1,
**dadurch gekennzeichnet, dass** das Isolationsmaterial (30) derart auf die Teilbereiche (32) aufgebracht wird, dass ein Gradient der Schichtdicke (D) des Isolationsmaterials (30) von der Längsmittelachse (60) zu den Rändern (38) des jeweiligen Teilbereiches (32) hin in einem Bereich zwischen 5% und 100% gebildet wird und/oder dass die Schichtdicke (D) des Isolationsmaterials (30) parallel zu der Längsachse (20) des Stapels (14) ausgehend von einer Mitte des jeweiligen Teilbereiches (32) zu zu der Längsachse (20) senkrecht verlaufenden Rändern (38) des Teilbereiches (32) hin stetig ausläuft.

3. Herstellungsverfahren nach einem der Ansprüche 1 oder 2,
**dadurch gekennzeichnet, dass** auf jeder der beiden Seitenflächen (22) eine Maske (40) mit den vordefinierten Teilbereichen (32) entsprechenden vordefinierten Öffnungen (42) in einem vorbestimmten Abstand (a) zu der Oberfläche (28) des Stapels (14) angeordnet wird, und dass das Isolationsmaterial (30) von einer dem Stapel (14) abgewandten Maskenseite (48) aus durch die Öffnungen (42) hindurch auf die vordefinierten Teilbereiche (32) der Oberfläche (28) des Stapels (14) aufgebracht wird, wobei die Maske (40) insbesondere in einem Abstand (a) von 0,1 mm bis 4 mm zu der Oberfläche (28) des Stapels (14) angeordnet wird, wobei die Maske (40) vorzugsweise schwebend über der Oberfläche (28) des Stapels (14) gehalten wird.

4. Herstellungsverfahren nach Anspruch 3,
**dadurch gekennzeichnet, dass** eine Maske (40) bereitgestellt wird, deren Öffnungen (42) so angeordnet sind, dass beim Aufbringen des Isolationsmaterials (30) auf die Oberfläche (28) des Stapels (14) auf jeder der beiden Seitenflächen (22) jede an die Oberfläche (28) des Stapels (14) hervortretende Elektrodenschicht (18) mit dem Isolationsmaterial (30) zumindest bereichsweise bedeckt wird, und/oder dass die Maske (40) als Einwegmaske (51), insbesondere an einem Endlosband (50), bereitgestellt wird, wobei die bereitgestellte Maske (40) aus einem temperatur- und lösungsmittelbeständigen Polymer, insbesondere aus einem faserverstärkten Kunststoff, gebildet ist.

5. Herstellungsverfahren nach einem der Ansprüche 1 bis 4,
**dadurch gekennzeichnet, dass** das Isolationsmaterial (30) als Lösung (46) bereitgestellt wird und auf die Oberfläche (28) des Stapels (14) aufgesprüht wird, wobei eine Viskosität der Lösung (46) insbesondere in einem Bereich zwischen 4 Pa·s und 8 Pa·s liegt.

6. Herstellungsverfahren nach einem der Ansprüche 1 bis 5,
**dadurch gekennzeichnet, dass** nach dem Aufbringen des Isolationsmaterials (30) auf die Oberfläche (28) des Stapels (14) an den beiden Seitenflächen (22) eine Schichtdicke (D) des Isolationsmaterials (30) vermessen wird, insbesondere durch optische Messung und/oder durch Wiegen, wobei das Vermessen insbesondere vor einem Trocknungs- und/oder Aushärteschritt durchgeführt wird.

7. Herstellungsverfahren nach einem der Ansprüche 1 bis 6,
**dadurch gekennzeichnet, dass** ein Trocknungsschritt zum Trocknen des Isolationsmaterials (30) durchgeführt wird, wobei das Isolationsmaterial (30) insbesondere bei einer Temperatur zwischen 40 °C und 80 °C und einer maximalen relativen Luftfeuchte von 30% getrocknet wird.

8. Herstellungsverfahren nach einem der Ansprüche 1 bis 7,
**dadurch gekennzeichnet, dass** ein Aushärteschritt zum Aushärten des Isolationsmaterials (30) durchgeführt wird, wobei das Isolationsmaterial (30) insbesondere bei einer Temperatur zwischen 280 °C und 360 °C an Luft ausgehärtet wird, wobei insbesondere ein Temperaturgradient von maximal 50 °C/min verwendet wird.

9. Elektromechanischer Aktor (10), insbesondere hergestellt mit einem Herstellungsverfahren nach einem der Ansprüche 1 bis 8, mit einem als Stapel (14) ausgebildeten elektrischen Bauelement (12), das aus einer Mehrzahl von Piezokeramikschichten (16) und aus einer Mehrzahl von Elektrodenschichten (18)gebildet ist, die entlang einer Längsachse (20) des Stapels (14) abwechselnd übereinander gestapelt sind, wobei die Elektrodenschichten (18) an wenigstens zwei sich gegenüberliegenden, parallel zu der Längsachse (20) angeordneten Seitenflächen (22) des Stapels (14) an eine Oberfläche (28) des Stapels (14) hervortreten, wobei der Stapel (14) auf vordefinierten Teilbereichen (32) der beiden Seitenflächen (22) ein Isolationsmaterial (30) aufweist, derart, dass eine Schichtdicke (D) des Isolationsmaterials (30) in Richtung senkrecht zu der Längsachse (20) des Stapels (14) ausgehend von einer Längsmittelachse (60) des jeweiligen Teilbereiches (32), die sich parallel zu der Längsachse (20) erstreckt, zu zu der Längsachse (20) parallel verlaufenden Rändern (38) des jeweiligen Teilbereiches (32) hin auslaufend ausgebildet ist, wobei in dem Isolationsmaterial (30) Gräben (52) gebildet sind, die entlang der Längsachse (20) jede zweite, von dem Isolationsmaterial (30) bedeckte Elektrodenschicht (18) freilegen, wobei die Gräben (52) beidseitig von den Rändern (38) der Teilbereiche (32) beabstandet angeordnet sind.

10. Elektromechanischer Aktor (10) nach Anspruch 9,
**dadurch gekennzeichnet, dass** ein jeweiliger Teilbereich (32) in einem Querschnitt senkrecht zu der Längsachse (20) des Stapels (14) eine trapezförmige Querschnittform mit einem Plateaubereich (56) aufweist.

## Claims

1. Production method for producing an electromechanical actuator (10), comprising the steps of:
- providing an electrical component (12), which is designed as a stack (14) and is formed from a plurality of piezoceramic layers (16) and from a plurality of electrode layers (18), which are stacked alternately one on top of the other along a longitudinal axis (20) of the stack (14), the electrode layers (18) protruding at a surface (28) of the stack (14) on at least two opposite side faces (22) of the stack (14) arranged parallel to the longitudinal axis (20);
- applying insulating material (30) to predefined subregions (32) of the two side faces (22) in such a way that, in a direction perpendicular to the longitudinal axis (20) of the stack (14), a layer thickness (D) of the insulating material (30) tapers steadily from a longitudinal centre axis (60) of the respective subregion (32) that extends parallel to the longitudinal axis (20) to edges (38) of the respective subregion (32) that run parallel to the longitudinal axis (20),
- forming in the insulating material (30) trenches (52) which expose every second electrode layer (18) covered by the insulating material (30) along the longitudinal axis (20), the trenches (52) being arranged on both sides at a distance from the edges (38) of the subregions (32).

2. Production method according to Claim 1,
**characterized in that** the insulating material (30) is applied to the subregions (32) in such a way that a gradient of the layer thickness (D) of the insulating material (30) from the longitudinal centre axis (60) to the edges (38) of the respective subregions (32) is formed in a range between 5% and 100% and/or **in that**, parallel to the longitudinal axis (20) of the stack (14), the layer thickness (D) of the insulating material (30) tapers steadily from a centre of the respective subregion (32) to edges (38) of the subregion (32) that run perpendicular to the longitudinal axis (20).

3. Production method according to either of Claims 1 and 2,
**characterized in that** a mask (40) with predefined openings (42), corresponding to the predefined subregions (32), is arranged on each of the two side faces (22) at a predetermined distance (a) from the surface (28) of the stack (14), and **in that** the insulating material (30) is applied from a mask side (48) facing away from the stack (14) through the openings (42) onto the predefined subregions (32) of the surface (28) of the stack (14), the mask (40) being arranged in particular at a distance (a) of 0.1 mm to 4 mm from the surface (28) of the stack (14), the mask (40) preferably being held in a suspended manner over the surface (28) of the stack (14).

4. Production method according to Claim 3,
**characterized in that** a mask (40) is provided, the openings (42) of which are arranged such that, when the insulating material (30) is applied to the surface (28) of the stack (14), on each of the two side faces (22) each electrode layer (18) protruding at the surface (28) of the stack (14) is covered at least in certain regions by the insulating material (30), and/or **in that** the mask (40) is provided as a disposable mask (51), in particular on an endless strip (50), the mask (40) that is provided being formed from a temperature- and solvent-resistant polymer, in particular from a fibre-reinforced plastic.

5. Production method according to one of Claims 1 to 4,
**characterized in that** the insulating material (30) is provided as a solution (46) and is sprayed onto the surface (28) of the stack (14), a viscosity of the solution (46) lying in particular in a range between 4 Pa·s and 8 Pa·s.

6. Production method according to one of Claims 1 to 5,
**characterized in that**, after the insulating material (30) has been applied to the surface (28) of the stack (14), a layer thickness (D) of the insulating material (30) at the two side faces (22) is measured, in particular by optical measurement and/or by weighing, the measuring being carried out in particular before a drying and/or curing step.

7. Production method according to one of Claims 1 to 6,
**characterized in that** a drying step for drying the insulating material (30) is carried out, the insulating material (30) being dried in particular at a temperature of between 40°C and 80°C and a maximum relative atmospheric humidity of 30%.

8. Production method according to one of Claims 1 to 7,
**characterized in that** a curing step for curing the insulating material (30) is carried out, the insulating material (30) being cured in particular at a temperature of between 280°C and 360°C in air, in particular a maximum temperature gradient of 50°C/min being used.

9. Electromechanical actuator (10), in particular produced by a production method according to one of Claims 1 to 8, with an electrical component (12), which is designed as a stack (14) and is formed from a plurality of piezoceramic layers (16) and from a plurality of electrode layers (18), which are stacked alternately one on top of the other along a longitudinal axis (20) of the stack (14), the electrode layers (18) protruding at a surface (28) of the stack (14) on at least two opposite side faces (22) of the stack (14) arranged parallel to the longitudinal axis (20), the stack (14) having an insulating material (30) on predefined subregions (32) of the two side faces (22) in such a way that, in a direction perpendicular to the longitudinal axis (20) of the stack (14), a layer thickness (D) of the insulating material (30) is formed such that it tapers from a longitudinal centre axis (60) of the respective subregion (32) that extends parallel to the longitudinal axis (20) to edges (38) of the respective subregion (32) that run parallel to the longitudinal axis (20), there being formed in the insulating material (30) trenches (52) which expose every second electrode layer (18) covered by the insulating material (30) along the longitudinal axis (20), the trenches (52) being arranged on both sides at a distance from the edges (38) of the subregions (32).

10. Electromechanical actuator (10) according to Claim 9,
**characterized in that** a respective subregion (32) has in a cross section perpendicular to the longitudinal axis (20) of the stack (14) a trapezoidal cross-sectional form with a plateau region (56).

## Revendications

1. Procédé de fabrication permettant de fabriquer un actionneur électromécanique (10), comprenant les étapes suivantes :
- fourniture d'un composant électrique (12) réalisé sous forme d'empilement (14), lequel composant est formé à partir d'une pluralité de couches piézocéramiques (16) et à partir d'une pluralité de couches d'électrodes (18) qui sont empilées de manière superposée en alternance le long d'un axe longitudinal (20) de l'empilement (14), dans lequel les couches d'électrodes (18) font saillie au niveau d'une surface (28) de l'empilement (14) au niveau d'au moins deux faces latérales (22) de l'empilement (14) opposées et disposées parallèlement à l'axe longitudinal (20) ;
- application de matériau isolant (30) sur des zones partielles prédéfinies (32) des deux faces latérales (22), de telle sorte qu'une épaisseur de couche (D) du matériau isolant (30) s'amincit de manière continue vers des bords (38) de la zone partielle respective (32) qui s'étendent parallèlement à l'axe longitudinal (20), dans une direction perpendiculaire à l'axe longitudinal (20) de l'empilement (14) à partir d'un axe médian longitudinal (60) de la zone partielle respective (32), lequel axe médian longitudinal s'étend parallèlement à l'axe longitudinal (20),
- formation de sillons (52) dans le matériau isolant (30), lesquels rendent visibles, le long de l'axe longitudinal (20), une couche d'électrode (18) sur deux recouverte par le matériau isolant (30), dans lequel les sillons (52) sont disposés, des deux côtés, de manière espacée des bords (38) des zones partielles (32).

2. Procédé de fabrication selon la revendication 1,
**caractérisé en ce que** le matériau isolant (30) est appliqué sur les zones partielles (32) de telle sorte qu'un gradient de l'épaisseur de couche (D) du matériau isolant (30) à partir de l'axe médian longitudinal (60) vers les bords (38) de la zone partielle respective (32) est formé dans une plage comprise entre 5% et 100% et/ou **en ce que** l'épaisseur de couche (D) du matériau isolant (30) s'amincit de manière continue parallèlement à l'axe longitudinal (20) de l'empilement (14) à partir d'un centre de la zone partielle respective (32) vers des bords (38) de la zone partielle (32) qui s'étendent perpendiculairement à l'axe longitudinal (20).

3. Procédé de fabrication selon l'une des revendications 1 ou 2,
**caractérisé en ce qu'**un masque (40) doté d'ouvertures prédéfinies (42) correspondant aux zones partielles prédéfinies (32) est disposé sur chacune des deux faces latérales (22) à une distance prédéterminée (a) par rapport à la surface (28) de l'empilement (14), et **en ce que** le matériau isolant (30) est appliqué sur les zones partielles prédéfinies (32) de la surface (28) de l'empilement (14) à partir d'un côté de masque (48) opposé à l'empilement (14), à travers les ouvertures (42), le masque (40) étant disposé en particulier à une distance (a) de 0,1 mm à 4 mm par rapport à la surface (28) de l'empilement (14), le masque (40) étant retenu de préférence de manière flottante au-dessus de la surface (28) de l'empilement (14).

4. Procédé de fabrication selon la revendication 3,
**caractérisé en ce qu'**un masque (40) est fourni, masque dont les ouvertures (42) sont disposées de telle sorte que lors de l'application du matériau isolant (30) sur la surface (28) de l'empilement (14) sur chacune des deux faces latérales (22), chaque couche d'électrode (18) faisant saillie au niveau de la surface (28) de l'empilement (14) est recouverte par le matériau isolant (30) au moins dans certaines zones, et/ou **en ce que** le masque (40) est fourni en tant que masque à usage unique (51), en particulier sur une bande sans fin (50), le masque fourni (40) étant formé à partir d'un polymère résistant à la température et aux solvants, en particulier à partir d'une matière synthétique renforcée par des fibres.

5. Procédé de fabrication selon l'une des revendications 1 à 4,
**caractérisé en ce que** le matériau isolant (30) est fourni sous forme de solution (46) et est pulvérisé sur la surface (28) de l'empilement (14), une viscosité de la solution (46) étant en particulier comprise dans une plage entre 4 Pa·s et 8 Pa·s.

6. Procédé de fabrication selon l'une des revendications 1 à 5,
**caractérisé en ce qu'**après l'application du matériau isolant (30) sur la surface (28) de l'empilement (14) sur les deux faces latérales (22), une épaisseur de couche (D) du matériau isolant (30) est mesurée, en particulier par mesure optique et/ou par pesage, la mesure étant effectuée en particulier avant une étape de séchage et/ou de durcissement.

7. Procédé de fabrication selon l'une des revendications 1 à 6,
**caractérisé en ce qu'**une étape de séchage pour le séchage du matériau isolant (30) est effectuée, le matériau isolant (30) étant séché en particulier à une température comprise entre 40 °C et 80 °C et une humidité de l'air relative maximale de 30%.

8. Procédé de fabrication selon l'une des revendications 1 à 7,
**caractérisé en ce qu'**une étape de durcissement pour le durcissement du matériau isolant (30) est effectuée, le matériau isolant (30) étant durci à l'air en particulier à une température comprise entre 280 °C et 360 °C, un gradient de température d'au maximum 50 °C/min étant en particulier utilisé.

9. Actionneur électromécanique (10), en particulier fabriqué à l'aide d'un procédé de fabrication selon l'une des revendications 1 à 8, comprenant un composant électrique (12) réalisé sous forme d'empilement (14), lequel composant est formé à partir d'une pluralité de couches piézocéramiques (16) et à partir d'une pluralité de couches d'électrodes (18) qui sont empilées de manière superposée en alternance le long d'un axe longitudinal (20) de l'empilement (14), dans lequel les couches d'électrodes (18) font saillie au niveau d'une surface (28) de l'empilement (14) au niveau d'au moins deux faces latérales (22) de l'empilement (14) opposées et disposées parallèlement à l'axe longitudinal (20), dans lequel l'empilement (14) comprend un matériau isolant (30) sur des zones partielles prédéfinies (32) des deux faces latérales (22), de telle sorte qu'une épaisseur de couche (D) du matériau isolant (30) est formée de manière à s'amincir de manière continue vers des bords (38) de la zone partielle respective (32) qui s'étendent parallèlement à l'axe longitudinal (20), dans une direction perpendiculaire à l'axe longitudinal (20) de l'empilement (14) à partir d'un axe médian longitudinal (60) de la zone partielle respective (32), lequel axe médian longitudinal s'étend parallèlement à l'axe longitudinal (20), dans lequel des sillons (52) sont formés dans le matériau isolant (30), lesquels rendent visibles, le long de l'axe longitudinal (20), une couche d'électrode (18) sur deux recouverte par le matériau isolant (30), dans lequel les sillons (52) sont disposés, des deux côtés, de manière espacée des bords (38) des zones partielles (32).

10. Actionneur électromécanique (10) selon la revendication 9,
**caractérisé en ce qu'**une zone partielle respective (32) présente, dans une section transversale perpendiculaire à l'axe longitudinal (20) de l'empilement (14), une forme en section transversale trapézoïdale présentant une zone de plateau (56).
